(19) Europäisches Patentamt
European Patent Office
Office européen des brevets

(11) EP 2 565 657 A1

(12) EUROPEAN PATENT APPLICATION

(43) Date of publication:
06.03.2013 Bulletin 2013/10

(51) Int Cl.:
G01R 31/26 (2006.01)  G01R 33/02 (2006.01)
G01R 33/04 (2006.01)  G01R 33/06 (2006.01)

(21) Application number: 11179749.4

(22) Date of filing: 01.09.2011

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(71) Applicant: Nederlandse Organisatie voor
Toegepast
-Natuurwetenschappelijk Onderzoek TNO
2628 VK Delft (NL)

(72) Inventor: Doodemann, Gerardus Johannes
Nicolaas
2628 VK Delft (NL)

(74) Representative: Jansen, Cornelis Marinus
VEREENIGDE
Johan de Wittlaan 7
2517 JR Den Haag (NL)

(54) **Apparatus for testing the interconnection of photovoltaic cells**

(57)    Apparatus for contactless testing a closed loop electrical connection in partcular suited for testing the interconnection of photovoltaic cells in a solar pane. The apparatus comprises tow coils. The first coil is a driving coil (11) comprising at least one first winding (15) for generating a varying magnetic field in the area (14) enclosed by the closed loop electrical connection. The second coil is a detection coil (12) comprising at least one second winding (16) for generating a voltage when being subjected to the magnetic field generated by the current in the closed loop electrical connection. The apparatus further comprises a compensation loop (13) for compensating the direct mutual induction of the first coil and the second coil. The compensation loop allows the use of uncomplicated electronics for testing the interconnection, which electronics can easily be implemented in a hand held device.

Fig. 2A

EP 2 565 657 A1

**Description**

The present invention relates to an apparatus for testing a closed loop electrical connection. More in particular it relates to an apparatus for testing the electrical interconnection of photovoltaic cells in a solar module comprising a multiple of photovoltaic cells, the apparatus comprising a first coil comprising at least one first winding for generating a varying magnetic field in the area enclosed by the closed loop electrical connection and a second coil comprising at least one second winding for generating a voltage when being subjected to the magnetic field generated by the current in the closed loop electrical connection.

State of the art

Individual photovoltaic cells, typically having the size of a silicon wafer, have to be combined for making solar panels or solar modules. More in particular the electrodes of different photovoltaic cells have to be connected with each other electrically. This interconnection of individual photovoltaic cells is fragile, in particular during the production process of combining the different cells in a solid solar panel. Furthermore the interconnection might be poor due to failure of materials or processing. Poor interconnections will result in a lower performance of the solar panel, possibly only after a certain laps of time during use. Such a lower performance might be a reduced efficiency resulting in a lower energy output or a reduced lifetime of the panel. For this reason it is desired to have an apparatus for testing the electrical connection both during the production process of the solar panel as well as afterwards. In particular it is desired to have a testing apparatus that allows testing without making mechanical contact with the photovoltaic cells or the solar panel.

A common type of photovoltaic cell comprises a metallized back electrode and a patterned front electrode. However, it is acknowledged that there are also other electrode configurations. A number of photovoltaic cells might be arranged in series by connecting the back electrode of a first photovoltaic cell with the front electrode of a second cell. Poor contact of the wiring between the photovoltaic cells will result in a high electrical resistance. Therefore, by measuring the resistance by well known resistance meters one can test the quality of the electrical contact. Making a mechanical contact during such a test, however, might damage the photovoltaic cell or making mechanical contact with the photovoltaic cells or solar panel might be difficult or even impossible after the solar panel has been produced.

From the German patent publication DE 4440167 an apparatus and method are known for measuring the current distribution in photovoltaic cells and other semiconductor elements. The local heating resulting from spots with a high electrical resistance is, according to this publication, detected by infrared measurement. This method is suited for detecting defects in homogeneous conductors but using this method for detecting defects in patterned structures is cumbersome.

From international patent publication WO 2008/017305 an apparatus and method are known for investigating defects in photovoltaic cells and solar modules. According to this known apparatus, the magnetic fields that are generated during use of the solar module are measured with special magnetic field detectors. According to this known method the investigation is performed when a current flows through the tracks and interconnections as a result of the light falling on the module. Therefore, this test can only be performed when the module under test is subjected to a sufficient intensity of light and the output of the module is connected to a load resistance to allow the flow of a current. Further, the interpretation of the test results is not easy whereas the measured magnetic fields have to be correlated with the resistance of the tracks and interconnections.

From Japanese patent publication JP2003-110122 a method is known for detecting faults of photovoltaic devices, which method is based on the detection of magnetic fields. The method comprises generating an eddy current in the back electrode film by a driving coil and detecting the induced magnetic field by a detecting coil. This publication also discloses an apparatus comprising two coils that are situated in parallel next to each other. A disadvantage of this known apparatus and method is that the driving coil induces directly a current or voltage in the detecting coil due to the direct mutual induction of the two coils, which current or voltage depends on the geometry of the measurement set-up, in particular the distance to the solar panel and the conductivity of the solar panel.

Summary of the invention

An objective of the present invention is to provide an apparatus for testing a closed loop electrical connection, more in particular an apparatus that is suitable for detecting defects in the electrical interconnection of photovoltaic cells in a solar module, which apparatus allows accurate contactless testing, is not complex and is easy to use.

A further objective of the present invention is to overcome problems and disadvantages of the above mentioned state of the art. In particular is it an objective to overcome the problem of the direct mutual induction of the driving coil and the detection coil which may result in a voltage in the second coil, even if no closed loop electrical connection is present.

This objective of the invention is obtained by an apparatus for testing a closed loop electrical connection, the apparatus comprising

- a first coil comprising at least one first winding for generating a varying magnetic field in the area enclosed by the closed loop electrical connection, and

- a second coil comprising at least one second winding for generating a voltage when being subjected to the magnetic field generated by the current in the closed loop electrical connection,

characterised in that the apparatus further comprises a compensation loop for compensating any direct mutual induction of the first coil and the second coil.

An advantage of a compensation loop is that such a loop eliminates or at least significantly reduces the direct mutual induction of the first coil which is the driving coil for generating an alternating magnetic field and the second coil which is the detection coil for detecting a magnetic field. When there is no or only a minor mutual induction of the two coils then the coupling of the driving coil and the detection coil is only or mainly determined by the properties of the loop under test.

The above mentioned objective is obtained with this advantage because the compensation by means of a compensation loop makes the measurement less sensitive to the environmental conditions such as the distance to the loop under test. It further allows an easy detection of the resistance of the closed loop because only the phase difference between the current of the driving coil and the voltage of the detection coil have to be measured, not the amplitude of the signal as will be illucidated in detail below.

Brief description of the figures

Figure 1A     two interconnected photovoltaic cells

Figure 1B     a closed loop electrical connection

Figure 2A     an embodiment of the apparatus in a first planar measurement set-up

Figure 2B     an embodiment of the apparatus in a second planar measurement set-up

Figure 3      an embodiment of the apparatus in a sandwich measurement set-up

Figure 4      a preferred embodiment with planar geometry

Figure 5      example of a compensation loop that is part of the detection coil

Figure 6A     top view of example of a compensation loop in the form of a closed separate winding

Figure 6B     side view of example of a compensation loop in the form of a closed separate winding

Figure 7      example of two compensation loops connect with the coils

Figure 8      embodiment of an electronic circuit

Figure 9      embodiment of a hand held apparatus

Detailed description the invention

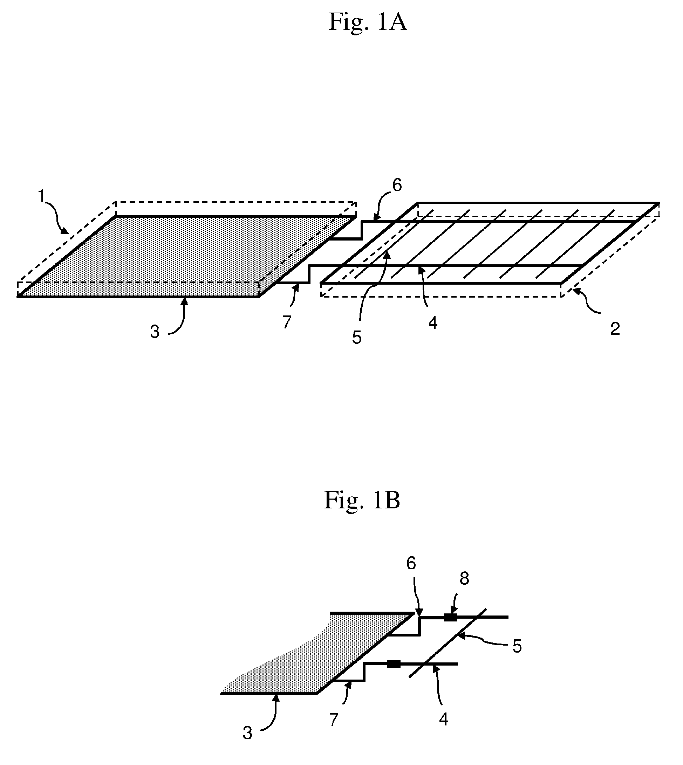

Photovoltaic cells or solar cells are semiconductor devices generating an electrical current when being subjected to light, more in particular to solar light. Often such solar cells are made out of silicon, either amorphous or (semi)crystalline silicon. Typically, the size of such a cell is approximately 15 by 15 centimeters (6 inch by 6 inch). Several photovoltaic cells are combined to solar panels which typically have a size of about one to two square meters. The voltage that is generated across a photovoltaic cell is typically only 0.5 Volt, whereas usually higher voltages are required. To obtain a higher voltage several photovoltaic cells of a panel are connected in series. In figure 1A is shown how two photovoltaic cells can be connected. For illustrative purpose only the back side of the left cell (1) and the front side of the right cell (2) are shown. The solar cells comprise a metallised layer (3) constituting the back side electrode and a structured conductive pattern at the front part of the cell, viz. the part of the cell that is directed towards the sun. Typically such a conductive pattern may comprise a few main tracks (4) with smaller branches (5). The main tracks are used for connectiing the photovoltaic cell to a power consuming device or to another cell to form a solar panel.

Two photovoltaic cells may be connected in series by connecting the back side electrode of a first cell with the front side electrode of a second cell. Typically, the back electrode of a first cell may be connected via two wires (6), (7) with the front electrode of the second cell. In such a geometry the back electrode (3) of a first cell, the front electrode tracks (4), (5) of a second cell and the wirings (6), (7) form an electrically closed loop as shown in figure 1B. This loop may comprise solder connections (8).

In case that the cells are connected in parallel instead of in series, there will also be closed loop provided that the front electrodes and/or the two back electrodes of the two photovoltaic cells are connected by at least two conductive tracks forming a closed conductive loop.

The electrical conductivity of the loop is determined by, among others, the electrode structure and the quality of the interconnection of the cells, including possible solder connections. When only one type of photovoltaic cell is used and one type of connection between the cells is applied for making the solar panel, variations of the measured conductivity of different pairs of cells can be attributed to the quality of the interconnection between those cells because other properties such as the size of the loop, the electrode structure and the materials used are the same for all the loops under test.

Japanese patent publication JP2003-110122 discloses that the conductivity of the back electrode of a photovoltaic cell can be determined contactlessly by inducing a current in the electrode by means of an alternating magnetic field generated by a driving coil. The present invention is based on the insight that not only the conductivity of a homogeneous layer but also the conductivity of a closed loop can be determined in such a way. In such closed loop the induced current is confined geometrically to the conductive tracks forming the loop, whereas in case of a homogeneous layer the current is distributed over an area that is, among others, determined by the size of the driving coil.

The apparatus according to the invention comprises two coils, a driving coil for generating a varying magnetic field and a detection coil for detecting a magnetic field. When a varying current flows through the driving coil, this coil generates an varying magnetic field around the coil. This varying magnetic field will induce an electrical current in a conductive loop that is placed in the vicinity of the coil. The loop may, for example, be formed by the interconnection of two photovoltaic cells as shown in figure 1B. The magnitude of the current depends, among others, on the relative orientation of the driving coil and the loop and on the electrical resistance of the loop. In case of an interconnection loop the resistance may, among others, be determined by solder connections (8) between wiring and electrodes. Preferably the area of the driving coil is less than the area of the loop under test, allowing the loop to enclose the maximum flux, also when the loop and coil are placed at a distance that is larger than, say, the diameter of the coil. However, the area of the coil may also be larger. In the latter case the calibration of the apparatus may need more attention and the output signal may be more sensitive for a varying distance between the coil and the loop, more in particular between the solar panel module under test and the apparatus comprising the driving coil.

The current in the loop under test will generate a magnetic field that will be picked-up by the detection coil. So the driving coil and the detection coil are coupled to each other via the loop under test. The strength of the coupling between the two coils largely depends on the properties of the loop, including for example the resistance of the connection between the solar cells. However, there is also a direct coupling, viz. a coupling that exists independently of the presence of a loop under test, between the two coils, which will influence the measurement. The inventor has found that this influence can be reduced or even eliminated by applying a compensation loop.

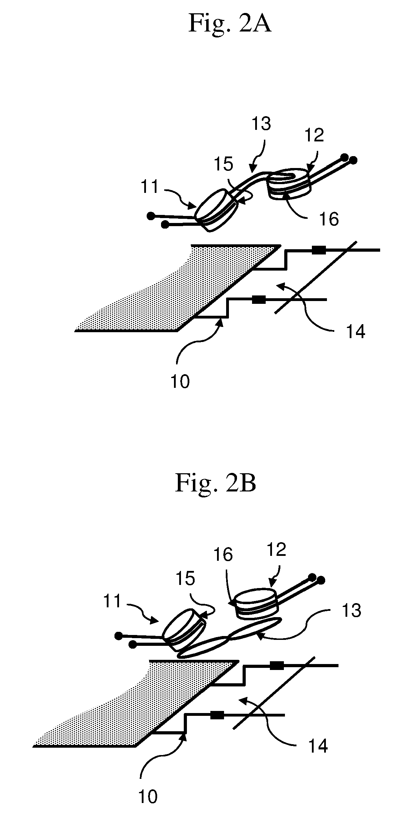

Figure 2A shows a schematic drawing of an embodiment of the apparatus and a closed loop electrical connection that is under test. The measurement set-up shown is a planar set-up, viz. both the driving coil and the detection coil are at the same side of the loop under test. The driving coil (11) comprises a few windings (15) for generating a varying magnetic field in the area (14) enclosed by the closed loop electrical connection (10). In use, the driving coil will be connected to an electrical current source for generating a magnetic field and it will be placed relative to the loop under test in such a way that a varying magnetic flux will go through the closed loop via the area (14) enclosed by the loop. Although such a varying magnetic flux may be obtained by a driving coil that is moving, for example rotating, relative to the loop, a static coil is preferred because of a simpler construction and easier signal analysis. The embodiment further comprises a detection coil (12). This detection coil (12) also comprises a few windings (16). This detection coil may be structurally identical to the driving coil, but it may also differ in for example the number of winding and the size. When this detection coil is subject to a varying magnetic field generated by a current in the loop under test, there will be a voltage accross the open ends of the coil. The ends of the coils are preferably connected to a voltage meter with a high imput impedance. However, the ends of the coils may also be short circuited for measuring the current in the coil.

The dimensions of the driving coil and the detection coil may depend on the size of the loop under test. More in particular the dimensions of the coils and their position relative to each other will preferably be chosen so as that a projection of the coils on the area enclosed by the loop undertest falls within that area. Among others such position and dimension allows testing of interconnection that are situated close to each other.

Those skilled in the art will appreciate that there is a mutual induction of the coils, more in particular that a voltage will be induced in the detection coil even in the absence of a closed loop. Or, in other words, that there is an electromagnetic coupling between the two coils. The strength of this coupling depends, among others, on the relative position and orientation of the two coils. To reduce this coupling, the apparatus further comprises a compensation loop (13) for compensating the direct mutual induction of the driving coil and the detection coil. In figure 2A, this compensation loop is shown as a part of the driving coil. However, as will be discussed in detail below, there are several other embodiments of the compensation loop.

During use of the apparatus the loop under test may face the coils as shown in figure 2A or the loop may face the compensation loop as shown in figure 2B. This implies that the compensation loop may be between the loop under test and the coils (see figure 2B) or that the coils may be situated between the loop under test and the compensation loop (see figure 2A).

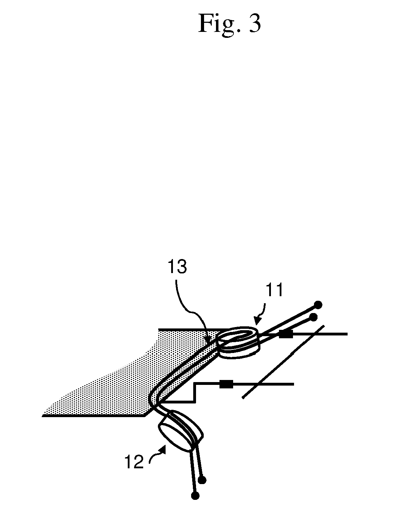

A geometry in which the apparatus during use is positioned at one side of the loop under test as shown in figures 2A and 2B allows an easy test, in particular when the apparatus is used as a hand-held device. However, the loop under test may also be placed between the driving coil (11) and the detection coil (12) in a sandwich geometry as is shown in figure 3. Such a sandwich geometry makes it more difficult to compensate for the mutual induction of the driving coil and the detection coil than in the planar geometry because the compensation loop (13) is prone to pick up noise signals due to the relative large distance between the two coils. However, such a sandwich geometry might be useful under special circumstances, for example in an automated production proces of solar modules where different sizes of interconnection loops have to be tested.

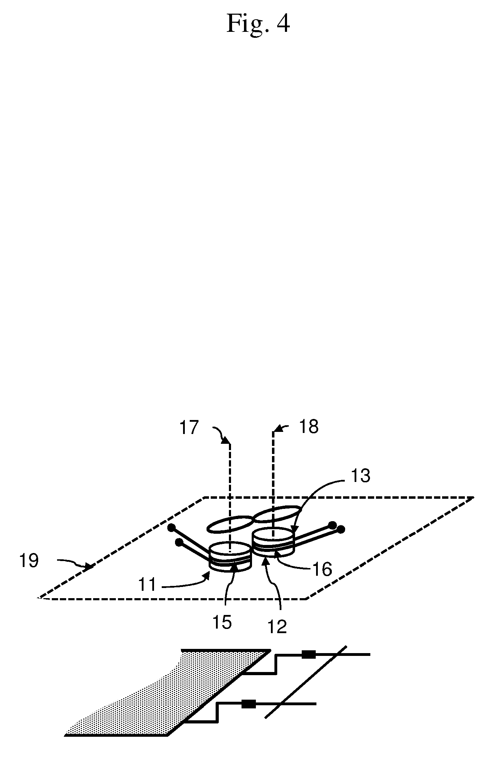

Figure 4 shows a schematic drawing of a preferred embodiment with planar geometry. The apparatus comprises two coils in parallel, a driving coil (11) and a detection coil (12). In parallel is understood as that the axes (17,18) of the two coils have an angle as small as practically possible. So in the ideal situation this angle is 0 degrees but when put into practise the angle may for example be less than 5 degrees. Each of the coils comprises at least one winding (15,16). Preferably, the two coils are situated in a plane (19) because in such a geometry the distance between the loop under test and the driving coil and between the loop under test and the detection coil is the same. However, one of the coils may also be displaced in the direction of an axis (17,18) perpendicular to the plane (19).

During use, a varying current flows through the driving coil (11), generating a magnetic field in the direction of the axis (17). The varying current preferably is an an alternating current (AC). The varying magnetic field induces a current in any closed conductive loop that is in the vicinity of the driving coil. For testing the interconnection of solar cells, this closed loop is formed by tracks, wires and solder connections as shown for example in figure 1B. The voltage across the detection coil (13) is a measure of the current in the loop under test, viz. of the electrical resistance of the loop.

Although the driving coil and the detection coil are placed in parallel to each other in the embodiment of figure 4, there will be a direct electromagnetic coupling between the two coils. Due to this coupling, the output voltage of the detection coil is not only determined by the properties of the loop under test but also by other factors. To eliminate, or at least reduce the direct coupling significantly, the apparatus further comprises a compensation loop (13) which will be discussed in detail below. During use the compensation loop may be situated between the coils and the loop under test as shown in figure 2B or the compensation loop and the loop under test may be at the opposite sides of the coils as shown in figure 2A.

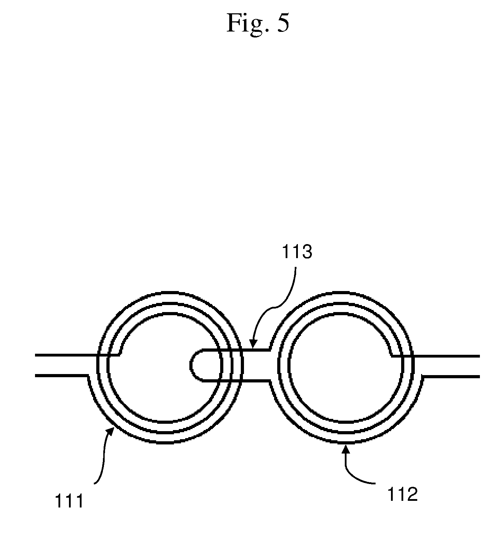

In one embodiment the compensation loop is part either of the detection coil or of the driving coil. The compensation loop comprises an extension of the coil, which extension at least partly covers the area of the other coil. So, if the extension (113) is part of the detection coil (112) as shown schematically in figure 5, than the extension will at least partly cover the driving coil (111). If the extension is part of the driving coil, the extension will at least partly cover the detection coil. It will be appreciated by those skilled in the art that there should be no galvanic contact between the extension and the coil of which the extension is not a part. In case that the detection coil and the driving coil are not made out of wires with an electrically insulating layer, special precautions have to be taken to avoid galvanic contact between the extension and the coil of which the extension is not a part.

The compensation loop overlapping the driving coil or the detection coil will compensate for the mutual induction of the driving coil and the detection coil. The exact dimensions and geometry of the extension and the amount of overlap can be determined for example experimentally by minimizing the signal in the detection coil in absence of the loop under test and any other closed conductive path.

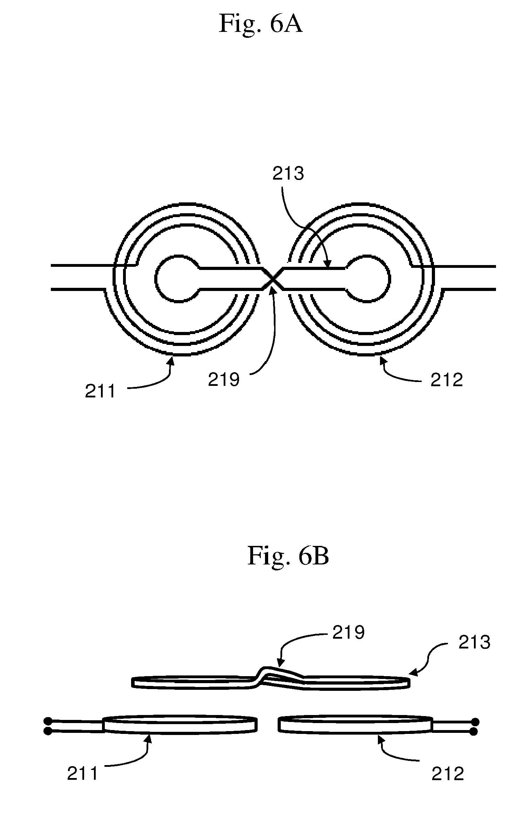

In another embodiment of the apparatus the loop is a closed separate winding as shown schematically in figure 6A. In this embodiment the winding is a turned winding (shaped for example like a number 8) configured so that there will be no net current when the winding is subject to a magnetic flux because the induced current in one part of the loop will counteract the current in the other -turned- part of the loop. The compensation loop is situated in the vicinity of the driving coil and the detecting coil such that the perpendicular projection of the turned winding on the plane of driving and detection coil mainly coincides with the two coils. This allows the turned compensation loop to enclose the maximum magnetic flux. Figure 6A shows a top or bottom view in the direction of the axes of the coils. Figure 6B a front or side view. In case when the driving coil and the detection coil are identical, also the two parts of the turned winding should be identical, viz. the area of the two turned parts of the loop should be the same. The loop can, for example, be made for out of wire or can be a conductive pattern on for example a printed circuit board or foil. For proper functioning, the wire may be covered with an electrically isolating material. This isolation may cover the whole wire or only cover it partially at the position (219) where the two parts of the loop cross each other as to avoid electrical contact at the crossing position.

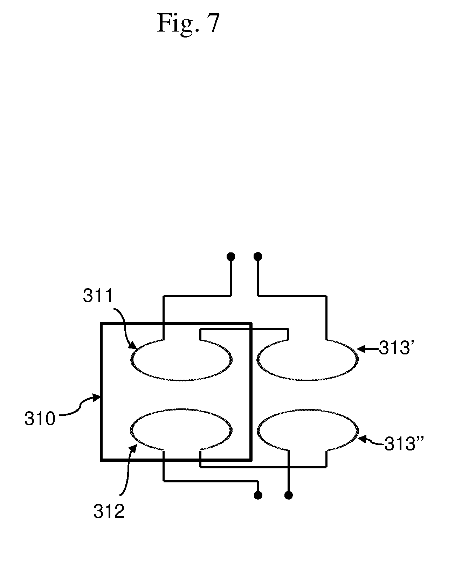

In a further embodiment of the apparatus a first compensation loop is a winding in series with the driving coil and a second compensation loop is a winding or a coil comprising a multiple of windings in series with the detection coil. Figure 7 shows such an embodiment. The first (313') and second (313") compensation loops are situated relative to each other in the same way as are the driving coil (311) and the detection coil (312). However, the compensation loops are situated such that when the apparatus is in use, the two compensation loops are not coupled via a conductive path, more in particular that they are not coupled via the interconnection loop (310) that has to be tested. The direction of the winding or windings of the compensation loop in series with the driving coil is opposite to the direction of the winding or windings of the compensation loop in series with the detection coil such that in absence of the loop under test or any other closed conductive path, the induced voltages over the detection coil and the compensation coil in series with the detection coil have equal magnitudes but opposite signs, leading to a zero induced voltage over the two coils in series.

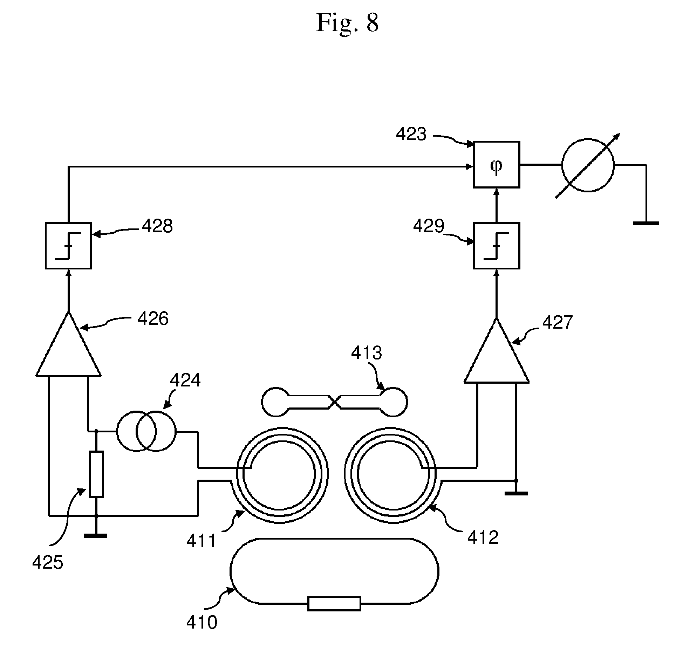

According to a further aspect of the invention the apparatus may comprise specific electronics that allow determining the difference in phase between the current in the driving coil and the voltage across the detection coil. Such an embodiment is shown in figure 8. In this embodiment a turned loop (413) is used as compensation loop. However, the specific electronics can also be applied in combination with different compensation loops. A current source (424) supplies the driving coil (411) with an alternating current with a frequency f. The current is transferred to a voltage via a resistor (425). The voltage is amplified by an amplifier (426) and clipped (428) to the maximum amplitude the amplifier can generate. This results in a block wave comprising the information about the phase of the current in coil (411). The voltage that is induced in the detection coil (412) is amplified by mains of a high impedance input amplifier (427) and clipped (429) to the maximum amplitude the amplifier can generate, resulting in a block wave comprising the information about the phase of the voltage across the detection coil. The signal with the phase information of the driving coil and the signal with the phase information from the detection coil are fed to a phase comparator (423) which gives an output signal that is representative for the phase difference. This phase difference is a measure for the electrical resistance of the loop under test as is explained below.

The relationship between the currents and the voltages in the driving coil with inductance $L_1$, detection coil with inductance $L_2$ and the interconnection loop with inductance $L_3$ is given by the following expressions in which index 1 relates to the driving coil, index 2 to the detection coil and index 3 to the interconnection loop:

$$U_1 = j\omega L_1 I_1 + j\omega M_{12} I_2 + j\omega M_{13} I_3$$

$$U_2 = j\omega M_{21} I_1 + j\omega L_2 I_2 + j\omega M_{23} I_3$$

$$U_3 = j\omega M_{31} I_1 + j\omega M_{32} I_2 + j\omega L_3 I_3$$

Here, $\omega$ is the angular frequency and M is the mutual induction of coils and loop. Because the mutual induction of the driving coil and the detection coil is neutralized by the compensation loop, the inductions $M_{12}$ (driving coil — detection coil) and $M_{21}$ (detection coil — driving coil) can be omitted. Further, the high impedance of the input of the amplifier suppresses the current $I_2$ in the detection coil:

$$U_1 = j\omega L_1 I_1 + j\omega M_{13} I_3$$

$$U_2 = j\omega M_{23} I_3$$

$$U_3 = j\omega M_{31} I_1 + j\omega L_3 I_3$$

Further, the current in the interconnection loop is determined by the resistance R of that loop:

$$U_3 = -I_3 R$$

The relationship between the voltage $U_2$ across the detection coil and the current $I_1$ in the driving coil therefore is given by:

$$U_2 = \frac{\omega^2 M_{31} M_{23}}{(R + j\omega L_3)} I_1$$

This time-dependent voltage has amplitude and a phase. The phase of the voltage is given by:

$$\phi = \arctan\left(\frac{-\omega L_3}{R}\right)$$

This phase is determined by the induction $L_3$ of the interconnection loop, viz. the dimension of the loop, the frequency of the applied current and the resistance of the interconnection loop. This equation illustrates that only measuring the difference in the phase of the current in the driving coil and the voltage across the detection coil satisfies for determining the resistance R of the interconnection if the inductance of the interconnection is known:

$$R = -\frac{\omega L_3}{\tan(\phi)}$$

The frequency can be chosen to have an optimal reading of an expected resistance range and a given inductance. For testing of interconnections in solar panels it is not always essential that the value of the resistance is known. It might satisfy that there is an indication, in the form of a different phase difference, that the interconnection under test has a higher resistance than a pre-set value. So, for example in an automated quality control, a critical phase difference can be set for acceptance of the interconnection.

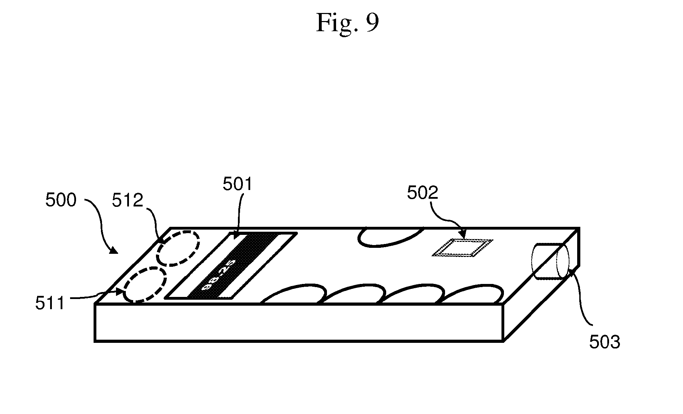

In a further embodiment, the apparatus can be hand-held for testing the connections. A schematic example of such a light weight portable embodiment is shown in figure 9. It is advantageous that such a hand held apparatus comprises a battery (503), either rechargeable or non-rechargeable, in order to test connections of, for instance, solar panels at places that are not easily accessible, like for example on roofs of houses. The apparatus can be switched on and off by an on/off button (502) to save the battery when the apparatus is not in use. The apparatus further may comprise a display (501) either just to indicate whether a connection under test satisfies pre-set characteristics or to shown a characteristic parameter of the loop under test, for example the resistance of the loop or the phase difference between the current in the driving coil (511) and the voltage across the detection coil (512). Instead of the display or in addition to the display the apparatus may comprise an optical indicator, for example a Light Emitting Diode or an acoustic indicator for indicating whether the loop under test satisfies pre-set conditions. The apparatus may comprise an electronic circuit als shown in figure 8 or any other suitable circuit and it may comprise an electronic memory for storing information and measurement data.

In a still further embodiment the apparatus is part of an automated production line for the production of solar panels. In such an embodiment the apparatus may comprise electronics for automated control of the connections. For example an alarm signal may be given as optic or acoustic signal indicating that the apparatus detected a bad connection. For quality safegarding the apparatus may comprise a memory for a database comprising the measured properties of the interconnections for future consultation.

Example

Frequency of the current in the driving coil is 1 MHz. The driving coil and the detection coil comprising a compensation loop in the form of an extension having an inductance of 691 nH and 706 nH respectively. A typical distance between the loop under test and the driving coil is 5 mm. This was shown to give good results for an interconnection with a typical dimension of 3 mm.

**Claims**

1.  Apparatus for testing a closed loop electrical connection (10), the apparatus comprising

    - a first coil (11) comprising at least one first winding (15) for generating a varying magnetic field in the area (14) enclosed by the closed loop electrical connection, and
    - a second coil (12) comprising at least one second winding (16) for generating a voltage when being subjected to the magnetic field generated by the current in the closed loop electrical connection,

**characterised in that**
the apparatus further comprises a compensation loop (13) for compensating any direct mutual induction of the first coil and the second coil.

2.  Apparatus according to claim 1 wherein the compensation loop (13) comprises a part (113) of the second coil (112) overlapping the first coil (111).

3.  Apparatus according to claim 1 wherein the compensation loop (13) comprises a turned loop (213) overlapping the first coil (211) and the second coil (212).

4.  Apparatus according to claim 1 comprising a first compensation loop (313') in series with the first coil (311), and a second compensation loop (313") in series with the second coil (312).

5.  Apparatus according to any of the preceding claims, further comprising an electronic circuit for determining the difference in phase between the current in the first coil and the voltage across the second coil.

6.  Apparatus according to any of the preceding claims, suitable for operation by battery power.

7.  Hand-held apparatus according to any of the preceding claims.

8.  Apparatus according to any of the preceding claims, wherein a first axis (17) perpendicular to the at least one first winding (15) and a second axis (18) perpendicular to the at least one second winding (16) are parallel.

9.  Apparatus according to claim 8, wherein the first winding (15) and the second winding (16) are situated in a same plane (19).

Fig. 1A

Fig. 1B

## Fig. 2A

## Fig. 2B

Fig. 3

Fig. 4

Fig. 5

Fig. 6A

Fig. 6B

Fig. 7

311

313'

310

313''

312

Fig. 8

Fig. 9

Europäisches
Patentamt

European
Patent Office

Office européen
des brevets

# EUROPEAN SEARCH REPORT

**Application Number**

EP 11 17 9749

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 0 604 810 A2 (ALCATEL STANDARD ELECTRICA [ES]) 6 July 1994 (1994-07-06) * abstract * * column 3, line 23 - column 4, line 19; figures 1-3 * | 1-9 | INV. G01R31/26 G01R33/02 G01R33/04 G01R33/06 |
| X | US 3 621 382 A (VALET JEAN-YVES) 16 November 1971 (1971-11-16) * abstract * * column 3, line 4 - column 8, line 22; figures 1-5 * | 1-9 | |
| X | US 4 130 242 A (MANNION ROBERT S) 19 December 1978 (1978-12-19) * abstract * * column 2, line 33 - column 5, line 60; figures 1-3 * | 1-9 | |
| X | EP 1 526 645 A1 (TURCK WERNER KG [DE]) 27 April 2005 (2005-04-27) * abstract * * page 4, paragraph [0016] - page 5, paragraph [0026]; figures 1-10 * | 1-9 | TECHNICAL FIELDS SEARCHED (IPC)  G01R |
| X | GB 2 425 610 A (UNIV LONDON [GB]; UNIV HOUSTON [US]) 1 November 2006 (2006-11-01) * abstract * * page 7, line 26 - page 9, line 12; figures 1-3 * | 1-9 | |
| X | ROVATI L ET AL: "Closed loop PCB Fluxgate without compensation coil", SENSORS, 2007 IEEE, IEEE, PI, 28 October 2007 (2007-10-28), pages 852-855, XP031221195, ISBN: 978-1-4244-1261-7 * the whole document * | 1-9 | |

-/--

The present search report has been drawn up for all claims

| Place of search | Date of completion of the search | Examiner |
|---|---|---|
| Munich | 23 March 2012 | Bergado Colina, J |

EPO FORM 1503 03.82 (P04C01)

Europäisches
Patentamt

European
Patent Office

Office européen
des brevets

# EUROPEAN SEARCH REPORT

Application Number

EP 11 17 9749

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | S. MIDDELHOEK: "Magnetic Field Measurement. November 1961.", IBM TECHNICAL DISCLOSURE BULLETIN, vol. 4, no. 6, 1 November 1961 (1961-11-01), pages 42-43, XP002672168, New York, US * the whole document * | 1-9 | |
| X | KEJK P ET AL: "A new compact 2D planar fluxgate sensor with amorphous metal core", SENSORS AND ACTUATORS A, ELSEVIER SEQUOIA S.A., LAUSANNE, CH, vol. 81, no. 1-3, 1 April 2000 (2000-04-01), pages 180-183, XP004191281, ISSN: 0924-4247, DOI: 10.1016/S0924-4247(99)00083-7 * the whole document * | 1-9 | |
| X | RIPKA P ET AL: "A.c. magnetic-field measurement using the fluxgate", SENSORS AND ACTUATORS A, ELSEVIER SEQUOIA S.A., LAUSANNE, CH, vol. 46, no. 1-3, 1 January 1995 (1995-01-01), pages 307-311, XP027205950, ISSN: 0924-4247 [retrieved on 1995-01-01] * the whole document * | 1-9 | **TECHNICAL FIELDS SEARCHED (IPC)** |
| A,D | JP 2003 110122 A (SANYO ELECTRIC CO) 11 April 2003 (2003-04-11) * abstract; figures 1-5 * | 1-9 | |
| | -/-- | | |

The present search report has been drawn up for all claims

| Place of search | Date of completion of the search | Examiner |
|---|---|---|
| Munich | 23 March 2012 | Bergado Colina, J |

EPO FORM 1503 03.82 (P04C01)

| | Europäisches Patentamt<br>European Patent Office<br>Office européen des brevets | **EUROPEAN SEARCH REPORT** | Application Number<br>EP 11 17 9749 |
|---|---|---|---|

## DOCUMENTS CONSIDERED TO BE RELEVANT

| Category | Citation of document with indication, where appropriate,<br>of relevant passages | Relevant<br>to claim | CLASSIFICATION OF THE<br>APPLICATION (IPC) |
|---|---|---|---|
| A,D | WO 2008/017305 A2 (SOLARWATT AG [DE];<br>KUENANZ STEFFEN [DE]; MUENCH MARKUS [DE])<br>14 February 2008 (2008-02-14)<br>* abstract; figures 1-3 * | 1-9 | |
| A | WO 2008/146184 A2 (NXP BV [NL]; BUTZMANN<br>STEFAN [DE]) 4 December 2008 (2008-12-04)<br>* abstract *<br>* figure 8 * | 1-9 | |
| A | WO 2010/082115 A1 (SENECA S R L [IT])<br>22 July 2010 (2010-07-22)<br>* abstract *<br>* page 7, line 15 - page 12, line 15;<br>figures 1-7 * | 1-9 | |
| | | | TECHNICAL FIELDS<br>SEARCHED (IPC) |

The present search report has been drawn up for all claims

| Place of search | Date of completion of the search | Examiner |
|---|---|---|
| Munich | 23 March 2012 | Bergado Colina, J |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

..............................................................................

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 11 17 9749

This annex lists the patent family members relating to the patent documents cited in the above-mentioned European search report.
The members are as contained in the European Patent Office EDP file on
The European Patent Office is in no way liable for these particulars which are merely given for the purpose of information.

23-03-2012

| Patent document cited in search report | | Publication date | Patent family member(s) | | Publication date |
|---|---|---|---|---|---|
| EP 0604810 | A2 | 06-07-1994 | CA | 2112656 A1 | 01-07-1994 |
| | | | EP | 0604810 A2 | 06-07-1994 |
| | | | ES | 2070701 A2 | 01-06-1995 |
| | | | US | 5428888 A | 04-07-1995 |
| US 3621382 | A | 16-11-1971 | BE | 739939 A | 16-03-1970 |
| | | | CH | 516168 A | 30-11-1971 |
| | | | DE | 1951230 A1 | 23-04-1970 |
| | | | ES | 372349 A1 | 16-09-1977 |
| | | | FR | 1585806 A | 30-01-1970 |
| | | | GB | 1241074 A | 28-07-1971 |
| | | | NL | 6915412 A | 14-04-1970 |
| | | | SE | 358475 B | 30-07-1973 |
| | | | US | 3621382 A | 16-11-1971 |
| US 4130242 | A | 19-12-1978 | GB | 2006497 A | 02-05-1979 |
| | | | US | 4130242 A | 19-12-1978 |
| EP 1526645 | A1 | 27-04-2005 | EP | 1526645 A1 | 27-04-2005 |
| | | | US | 2005184814 A1 | 25-08-2005 |
| GB 2425610 | A | 01-11-2006 | AU | 2006243046 A1 | 09-11-2006 |
| | | | CA | 2606331 A1 | 09-11-2006 |
| | | | EP | 1875259 A2 | 09-01-2008 |
| | | | EP | 2267471 A1 | 29-12-2010 |
| | | | GB | 2425610 A | 01-11-2006 |
| | | | JP | 2008539411 A | 13-11-2008 |
| | | | US | 2009201016 A1 | 13-08-2009 |
| | | | WO | 2006117530 A2 | 09-11-2006 |
| JP 2003110122 | A | 11-04-2003 | NONE | | |
| WO 2008017305 | A2 | 14-02-2008 | DE | 102006037586 A1 | 28-02-2008 |
| | | | WO | 2008017305 A2 | 14-02-2008 |
| WO 2008146184 | A2 | 04-12-2008 | CN | 101680740 A | 24-03-2010 |
| | | | EP | 2153165 A2 | 17-02-2010 |
| | | | US | 2010321014 A1 | 23-12-2010 |
| | | | WO | 2008146184 A2 | 04-12-2008 |
| WO 2010082115 | A1 | 22-07-2010 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 4440167
- WO 2008017305 A
- JP 2003110122 A